# EUROPÄISCHE PATENTSCHRIFT

(11) **EP 1 623 483 B1**
(45) Veröffentlichungstag und Bekanntmachung des Hinweises auf die Patenterteilung: **04.10.2006**
(21) Anmeldenummer: 04709574.0
(22) Anmeldetag: 10.02.2004
(51) Int. Cl.: H01R 12/12, H01R 12/04, H05K 3/36

(54) **KONTAKTIERUNGSVORRICHTUNG FÜR FLEXIBLE FLACHBANDLEITER**
CONTACTING DEVICE FOR A FLEXIBLE RIBBON CONDUCTOR
DISPOSITIF DE METALLISATION POUR CONDUCTEUR A RUBAN FLEXIBLE

(30) Priorität: 12.05.2003 DE 10321184
(43) Veröffentlichungstag der Anmeldung: 08.02.2006
(73) Patentinhaber: Conti Temic microelectronic GmbH, 90411 Nürnberg (DE)
(72) Erfinder: JAHN, Michael, 02977 Hoyerswerda (DE)
(86) Internationale Anmeldenummer: PCT/DE2004/000227
(87) Internationale Veröffentlichungsnummer: WO 2004/105189

(56) Entgegenhaltungen:
- EP-A- 0 026 568
- DE-A- 10 157 113
- US-A- 4 252 392

## Beschreibung

Die Erfindung bezieht sich auf eine Kontaktierungsvorrichtung zur Kontaktierung eines flexiblen Flachbandleiters an einer Leiterplatte. Das Dokument EP-A-0 026 568 zeigt eine solche Vorrichtung.

Vorgefertigte Flachbandleiter, insbesondere sogenannte Folienleiter, finden heutzutage vielfach anstelle gewöhnlicher Leiterdrähte Einsatz bei der elektrischen Verkabelung von Maschinen. Insbesondere werden Flachbandleiter häufig in der Kraftfahrzeugtechnik als Bestandteile eines Bordnetzes verwendet. Es sind insbesondere zwei verschiedene Arten von Flachbandleitern üblich. Bei einem.sogenannten folienisolierten Flachbandleiter (FFC) sind Metallbänder oder -drähte in einem folienartigen Isoliermaterial eingebettet. Alternativ werden sogenannte gedruckte Folienschaltungen (FPC) verwendet, bei denen die Leiterbahnen auf eine isolierende Grundfolie aufgedruckt oder aufgespritzt sind.

Zur Herstellung eines elektrischen Kontakts zwischen einem Flachbandleiter und einer Leiterplatte wird üblicherweise der Flachbandleiter endseitig mit einem Steckverbinder versehen, dessen körrespondierendes Gegenstück an der Leiterplatte angebracht ist. Die mechanische und elektrische Verbindung zwischen dem Flachbandleiter und dem Steckverbinder erfolgt zumeist durch Löten und/oder Krimpen und ist deshalb vergleichsweise aufwändig. Wünschenswert wäre eine Kontaktierungsvorrichtung, die eine unmittelbare Kontaktierung des Flachbandleiters erlaubt, ähnlich wie dies bei der Kontaktierung einfacher Leitungsdrähten üblich ist. Die Kontaktierungsvorrichtung sollte einen sicheren und zerstörungsfreien mechanischen Halt für den Flachbandleiter gewähren. Der Flachbandleiter sollte ferner bei Bedarf zerstörungsfrei aus der Kontaktierungsvorrichtung lösbar sein.

Der Erfindung liegt die Aufgabe zugrunde, eine im Hinblick auf die oben genannten Anforderungen verbesserte Kontaktierungsvorrichtung zur Kontaktierung eines flexiblen Flachbandleiters an einer Leiterplatte anzugeben.

Diese Aufgabe wird erfindungsgemäß gelöst durch die Merkmale des Anspruchs 1. Danach umfasst die Kontaktierungsvorrichtung mindestens ein Kontaktelement, welches mit einem Befestigungsende an der Leiterplatte befestigt ist. Das oder jedes Kontaktelement ist mit einem Klemmende versehen, das in einer Ruhelage unter Vorspannung an der Leiterplatte anliegt. Es ist weiterhin ein Handhabungselement vorgesehen, mittels welchem das Klemmende des oder jedes Kontaktelements aus der Ruhelage in eine Öffnungslage auslenkbar ist. Die Öffnungslage ist dadurch ausgezeichnet, dass das oder jedes Klemmende von der Leiterplatte genügend beabstandet ist, um das Ende eines zu kontaktierenden Flachbandleiters zwischen dem oder jedem Klemmende einerseits und der Leiterplatte andererseits drucklos einzuführen. Die Wirkung des Handhabungselements auf das Kontaktelement ist hierbei reversibel. D.h., dass durch Betätigung des Handhabungselements das Klemmende des oder jedes Kontaktelements aus der Öffnungslage wieder in die Ruhelage zurückverfahren werden kann. Ein zwischen dem mindestens einen Klemmende und der Leiterplatte eingeschobener Flachbandleiter wird dabei zwischen dem oder jedem Klemmende und der Leiterplatte verklemmt und hierdurch mit der Leiterplatte kontaktiert.

Die erfindungsgemäße Kontaktierungsvorrichtung erlaubt eine direkte Kontaktierung des Flachbandleiters mit der Leiterplatte, ohne dass hierzu zunächst ein Steckverbinder mit dem Flachbandleiter verbunden werden müsste. Die Kontaktierung erfolgt über eine einfache Klemmverbindung. Arbeitsaufwendige Montageschritte, wie z.B. Löten oder Krimpen sind zur Kontaktierung des Flachbandleiters nicht erforderlich. Gleichzeitig ist ein guter und langzeitstabiler elektrischer Kontakt zwischen dem Flachbandleiter und der Leiterplatte sichergestellt.

Für eine vereinfachte Montage der Kontaktierungsvorrichtung und einen stabilen Sitz des Kontaktelements ist das Befestigungsende des oder jedes Kontaktelements bevorzugt in die Leiterplatte eingepresst. Alternativ kann das Befestigungsende des oder jeden Kontaktelements jedoch auch mit der Leiterplatte verlötet werden. Zumal ein Flachbandleiter üblicherweise mehrere Leiterbahnen enthält, sind zweckmäßigerweise mehrere, insbesondere eine der Anzahl der Leiterbahnen entsprechende Zahl von Kontaktelementen vorgesehen, deren Klemmenden mittels des Handhabungselements simultan auslenkbar sind.

In bevorzugter Ausbildung ist.das oder jedes Kontaktelement bandartig oder stabartig ausgebildet und weist eine hakenartig gebogene Form auf. An einen das Befestigungsende tragenden Bereich des Kontaktelements schließt dementsprechend ein Bogensegment an, an welches wiederum ein das Klemmende tragender Bereich anschließt. Das Befestigungsende ist bevorzugt etwa senkrecht zur Ebene der Leiterplatte ausgerichtet, während der das Klemmende tragende Bereich wiederum diagonal auf die Leiterplatte zugebogen ist. Das Klemmende ist bezüglich der Leiterplatte zweckmäßigerweise konvex gekrümmt, um scharfe Kanten im Klemmbereich zu vermeiden.

In einer besonderes vorteilhaften Ausbildung umfasst das Handhabungselement eine zur Leiterplatte parallele und drehbeweglich geführte Achse, von der mindestens ein Hebelarm etwa radial absteht. Das Bogensegment des oder jedes Kontaktelements ist hierbei insbesondere dicht um den Umfang des Achse herumgeführt, so dass das oder jedes Kontaktelement die Achse ähnlich einer Klammer umgreift. Die Auslenkung des oder jedes Kontaktelements geschieht auf konstruktiv besonders einfache Weise mittels eines Exzentervorsprungs, der zumindest auf axiale Höhe mit jedem Kontaktelement an der Achse vorgesehen ist. Dieser Exzentervorsprung wird bei Verschwenkung des Handhabungselements von einer Schließstellung in eine Öffnungsstellung gegen das oder jedes Kontaktelement verschoben. Der Exzentervorsprung verbiegt dabei das Kontaktelement derart, dass das Klemmende des Kontaktelements aus der Ruhelage in die Öffnungslage ausgelenkt wird. In der Schließstellung des Handhabungselements ist der Exzentervorsprung dagegen aus dem Anlagebereich des Kontaktelements mit der Achse, d.h. dem Winkelbereich, in welchem das Kontaktelement dicht um den Umfang der Achse herumgeführt ist, herausgedreht. Das Kontaktelement wird dabei durch die eigene Vorspannung in die Ruhelage zurückgedrückt.

In der Schließstellung des Handhabungselements steht zweckmäßigerweise mindestens ein Hebelarm etwa parallel zur Leiterplatte in Richtung des Klemmbereichs ab. Um eine mechanische Zugsicherung für einen kontaktierten Flachbandleiter zu gewährleisten, ist dieser Hebelarm vorteilhafterweise mit einem Haltedorn versehen, dessen Freiende in der Schließstellung dicht an der Leiterplatte anliegt oder sogar in diese eindringt. Diese Haltdorn ist dafür vorgesehen, in Schließstellung des Handhabungselements einen kontaktierten Flachbandleiter zu durchdringen und diesen somit mechanisch an der Leiterplatte zu fixieren.

Um zu verhindern, dass sich die Kontaktierungsvorrichtung unbeabsichtigt öffnet, ist das Handhabungselement vorteilhafterweise mit Rastmitteln versehen, mittels welchen es in der Schließstellung und fixierbar' ist. Die Rastmittel sind hierbei derart gestaltet, dass eine zerstörungsfreie Entrastung des Handhabungselements möglich ist.

In einer vorteilhaften Weiterentwicklung der Kontaktierungsvorrichtung ist an beiden Längsenden der Achse je ein Stützelement vorgesehen. Die Stützelemente dienen.hierbei zum einen der drehbaren Lagerung der Achse. Weiterhin erstrecken sich die Stützelemente bevorzugt in Richtung des Klemmbereichs und dienen somit zur seitlichen Führung des zu kontaktierenden Flachbandleiters. Der Flachbandleiter wird hierdurch zwangsweise derart justiert, dass sich jeweils ein Kontaktelement im Bereich einer Leiterbahn des Flachbandleiters befindet. Für eine verbesserte.Führung des Flachbandleiters ist zweckmäßigerweise zwischen jedem Stützelement und der Leiterplatte eine Führungsnut für den Flachbandleiter gebildet. Die Stützelemente dienen ferner als konstruktiv einfaches Widerlager für die Rastmittel des Handhabungselements, um dessen Verrastung in seiner Schließstellung zu gewährleisten.

Nachfolgend wird ein Ausführungsbeispiel der Erfindung anhand einer Zeichnung näher erläutert. Darin zeigen:
- FIG 1: in Explosionsdarstellung eine Kontaktierungsvorrichtung zur Kontaktierung eines Flachbandleiters mit einer Leiterplatte,
- FIG 2: in einem Längsschnitt die geschlossene Kontaktierungsvorrichtung vor Einführung des Flachbandleiters,
- FIG 3: die geöffnete Kontaktierungsvorrichtung beim Einführen des Flachbandleiters, und
- FIG 4: die wiederum geschlossene Kontaktierungsvorrichtung bei eingelegtem und kontaktiertem Flachbandleiter.

Einander entsprechende Teile sind in den Figuren stets mit dem gleichen Bezugszeichen versehen.

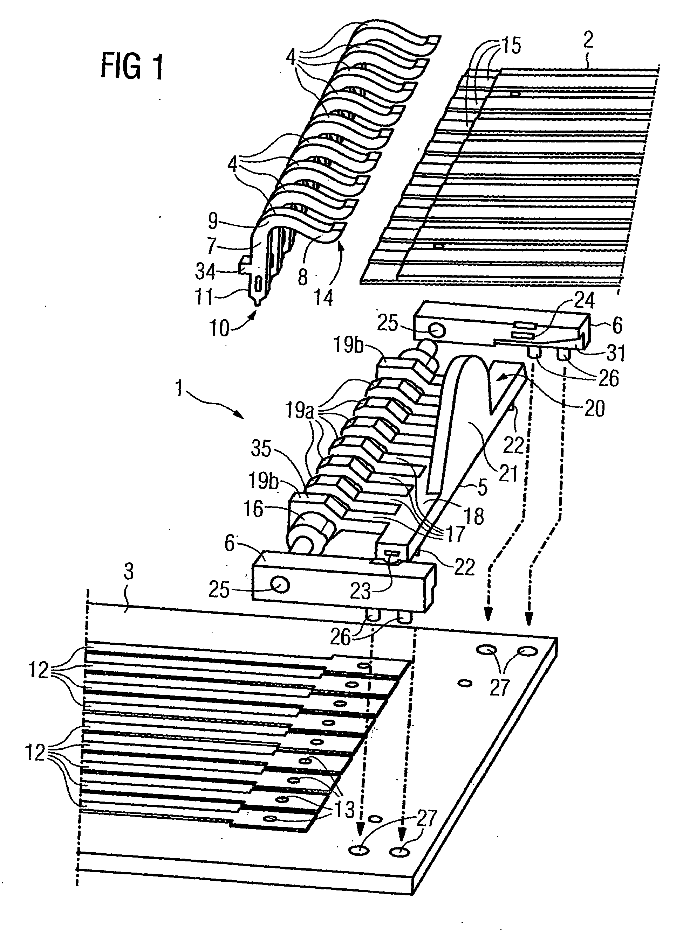

FIG 1 zeigt eine Kontaktierüngsvorrichtung 1 zur Kontaktierung eines Flachbandleiters 2 mit einer Leiterplatte 3. Die Kontaktierungsvorrichtung 1 umfasst in einem engeren Sinn eine Anzahl von (im Ausführungsbeispiel neun) Kontaktelementen 4, ein Handhabungselement 5 sowie zwei Stützelemente 6. Insofern als die Leiterplatte 3 herangezogen wird, um die Kontaktelemente 4, die Stützelemente 6 und das Handhabungselement 5 zueinander in einer bestimmten räumlichen Position zu halten, ist in einem erweiterten Sinne auch die Leiterplatte 3 als Bestandteil der Kontaktierungsvorrichtung 1 zu betrachten.

Das oder jedes Kontaktelement 4 ist im Wesentlichen ein aus einem Metallstreifen oder Metallstab gebildetes Stanzteil, das in eine hakenähnliche Form gebogen ist. Das Kontaktelement 4 umfasst einen Befestigungsschenkel 7 und einen Klemmschenkel 8, die in einem spitzen Winkel zueinander angeordnet sind und über ein Bogensegment 9 miteinander verbunden sind. Das Freiende des Befestigungsschenkels 7, nachfolgend als Befestigungsende 10 bezeichnet, dient zur Befestigung des Kontaktelements 4 an der Leiterplatte 3. Das Befestigungsende 10 ist hierfür mit einem geschlitzten Kontaktschwert 11 versehen, das zum Einpressen in eine korrespondierende, im Bereich einer Leiterbahn 12 der Leiterplatte 3 angeordnete Bohrung 13 vorgesehen ist. Das Befestigungsende 10 ist weiterhin mit einem seitlich aus dem Befestigungsschenkel 7 hervorstehenden Anschlag 34 versehen, der den Einpressweg des Befestigungsendes 10 in der Bohrung 13 begrenzt. Das Freiende des Klemmschenkels 8, nachfolgend als Klemmende 14 bezeichnet, ist zur Kontaktierung einer Leiterbahn 15 des Flachbandleiters 2 vorgesehen. Das Kontaktelement 4 ist im Bereich des Klemmendes 14 entgegen der Krümmungsrichtung des Bogensegments 9 umgebogen, so dass das Kontaktelement 4 in Seitenansicht auch eine einem Buchstaben "S" ähnliche Form aufweist. Das Klemmende 14 ist dadurch insbesondere bezüglich der Leiterplatte 3 konvex gekrümmt.

Das Handhabungselement 5 umfasst eine Achse 16, von der in regelmäßigen axialen Abständen Hebelarme 17 in radialer Richtung abstehen. Die (im Ausführungsbeispiel acht) Hebelarme 17 sind zueinander parallel orientiert und an ihrem jeweiligen, von der Achse 16 abgewandten Ende durch einen gemeinsamen Querbalken 18 verbunden. Der Querbalken 18 und die Hebelarme 17 bilden somit eine kammartige Form. Im Ansatz jedes Hebelarms 17 an der Achse 16 ist die Achse 16 zu einer scheibenartigen Ausformung verbreitert, die nachfolgend als Ansatzscheibe 19a,19b bezeichnet ist. Die in axialer Richtung inneren Ansatzscheiben 19a besitzen einen im Wesentlichen achtekkigen Querschnitt. Abweichend davon weisen die beiden in Axialrichtung jeweils äußersten Ansatzscheiben 19b die Querschnittsform eines modifizierten Achtecks auf, dessen rückwärtiges oberes Viertel zu einer Rechteckkontur 35 ausgeformt ist. Als "rückwärtig" ist die vom Querbalken 18 abgewandte Seite des Handhabungselements 5 bezeichnet. Als "oben" ist diejenige Seite des Handhabungselements 5 bezeichnet, die bei auf der Leiterplatte 3 montiertem, geschlossenem Handhabungselement 5 von der Leiterplatte 3 abgewandt ist. Der Querbalken 18 ist an seiner Oberseite 20 mit einem nach oben abragenden Griff 21 versehen. Die entgegengesetzte (in FIG 1 nicht sichtbare) Unterseite des Querbalkens 18 trägt zwei nach unten abragende Haltedornen 22. Der Querbalken 18 ist stirnseitig, d.h. in axialer Richtung, jeweils mit einer Rastnase 23 versehen, die mit einer Rastaufnahme 24 des benachbarten Stützelements 6 korrespondiert.

Die Stützelemente 6 sind als im Wesentlichen quaderförmige, seitliche Wände ausgebildet, die jeweils eine Bohrung 25 zur drehbaren Lagerung der Achse 16 aufweisen. Jedes Stützelement 6 ist an einer (in FIG 1 nicht sichtbaren) Unterseite mit zwei dübelartigen Vorsprüngen 26 versehen, die in entsprechende Aufnahmen 27 der Leiterplatte 3 einpressbar sind.

In montiertem Zustand ist die Achse 16 endseitig jeweils in die zugehörige Bohrung 25 des jeweils angrenzenden Stützelements 6 eingeschoben. Die Stützelemente 6 sind auf der Leiterplatte 3 befestigt, indem die Vorsprünge 26 in die zugehörigen Aufnahmen 27 eingepresst sind. Damit ist die Achse 16 des Handhabungselements 5 parallel zur Leiterplatte 3 und senkrecht zu deren Leiterbahnen 12 drehbar gelagert. Weiterhin sind die Kontaktelemente 4 mit ihrem jeweiligen Befestigungsende 10 in die jeweils zugehörige Bohrung 13 der Leiterplatte 3 eingepresst, so dass jedes Kontaktelement 4 an seinem Befestigungsende 10 an der Leiterplatte 3 fixiert ist und jeweils mit einer zugehörigen Leiterbahn 12 der Leiterplatte 3 leitend verbunden ist. Jedes Kontaktelement 4 umgreift dabei die Achse 16 nach Art einer Klammer. Die Kontaktelemente 4 sind in axialer Richtung versetzt zu den Ansatzscheiben 19a,19b angeordnet, so dass (mit Ausnahme der beiden äußersten Kontaktelemente 4) jedes Kontaktelement 4 zwischen zwei Ansatzscheiben 19a,19b einliegt.

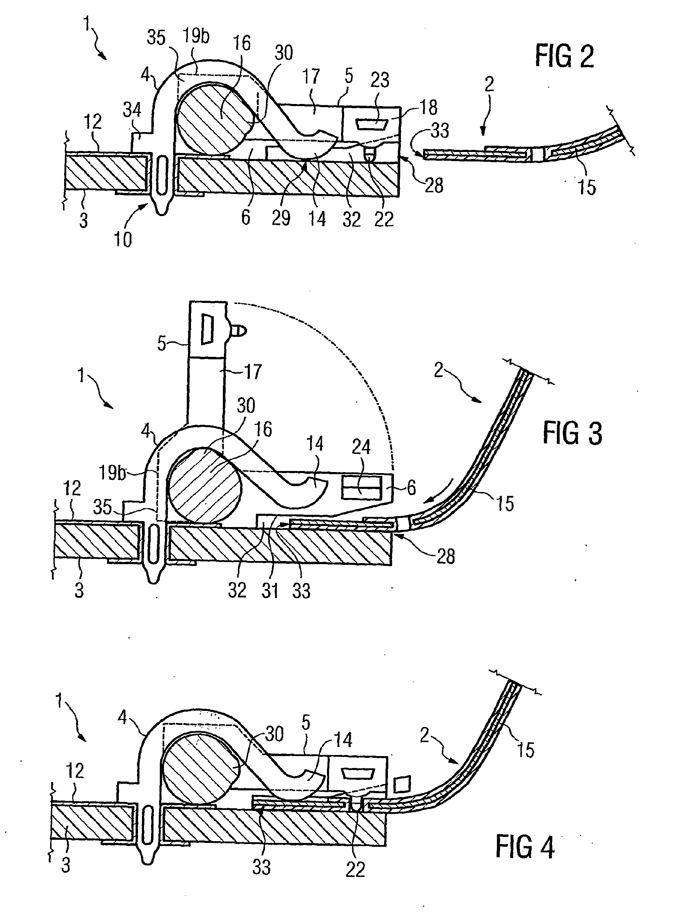

Dies ist in den FIG 2 bis 4 in einem schematischen Schnitt näher dargestellt. FIG 2 zeigt die Kontaktierungsvorrichtung 1 vor Kontaktierung des Flachbandleiters 2. Das Handhäbungselement 5 befindet sich hierbei in einer Schließstellung, in der die Hebelarme 17 etwa parallel zur Ebene der Leiterplatte 3 ausgerichtet sind und in Richtung eines Einführendes 28 für den Flachbandleiter 2 weisen. In der Schließstellung sind die Rastnasen 23 (in nicht näher dargestellter Weise) an den korrespondierenden Rastaufnahme 24 der Stützelemente 6 verrastet. Die Haltedorne 22 liegen in der Schließstellung des Handhabungselements 5 dicht an der Leiterplatte 3 an oder dringen sogar in diese ein.

Mit der Schließstellung des Handhabungselements 5 korrespondiert eine Ruhelage des oder jedes Kontaktelements 4. Das Kontaktelement 4 umgibt den Umfang der Achse 16 dicht, d.h. es liegt locker am Umfang der Achse 16 an oder umgibt diese mit geringem Abstand, während das Klemmende 14 des Kontaktelements 4 unter Vorspannung an der Leiterplatte 3 anliegt. Der Klemmbereich 29, in dem das Klemmende 14 an der Leiterplatte 3 anliegt, ist dabei insbesondere zwischen der Achse 16 und dem Querbalken 18 des Handhabungselements 5 angeordnet. Das Kontaktelement 4 greift also zwischen den kammzinkenartigen Hebelarmen 17 hindurch.

Zum Einführen des Flachbandleiters 2 in die Kontaktierungsvorrichtung 1 wird gemäß FIG 3 das Handhabungselement 5 aus der Verrastung mit den Stützelementen 6 gelöst. Dies kann beispielsweise dadurch geschehen, dass die Stützelemente 6 mittels eines Schraubendrehers aufgespreizt werden. Anschließend wird das Handhabungselement 5 um die Achse 16 in eine Öffnungsstellung verschwenkt, in der die Hebelarme 17 senkrecht von der Leiterplatte 3 abstehen. Die Rechteckkontur 35 der äußeren Ansatzscheiben 19b dient hierbei als Anschlag, der eine Verschwenkung des Handhabungselements 5 über dessen Öffnungsstellung hinaus verhindert. Bei der Verschwenkung des Handhabungselements 5 in dessen Öffnungsstellung wird das oder jedes Kontaktelement 4 in eine Öffnungslage ausgelenkt, in der das Klemmende 14 von der Leiterplatte 3 genügend beabstandet ist, um den Flachbandleiter 2 drucklos zwischen dem Klemmende 14 und der Leiterplatte 3 einschieben zu können. Zur Auslenkung der Kontaktelemente 4 trägt die Achse 16 einen Exzentervorsprung 30. Dieser Exzentervorsprung 30 steht etwa in der gleichen Richtung von der Achse 16 ab wie die Hebelarme 17 und ist zumindest im Bereich jedes Kontaktelements 4 ausgebildet.

In der in FIG 2 dargestellten Schließstellung des Handhabungselements 5 steht der Exzentervorsprung 30 in keinem direkten mechanischen Kontakt mit dem Kontaktelement 4. Dies ändert sich, wenn das Handhabungselement 5 aus seiner Schließstellung in seine Öffnungsstellung verschwenkt wird. Der Exzentervorsprung 30 wird hierbei in den Anlagebereich, d.h. das Bogensegment, in welchem das Kontaktelement 4 den Umfang der Achse 16 dicht umgibt, hineinverschwenkt. Der Exzentervorsprung 30 beaufschlagt hierbei das oder jedes Kontaktelement 4 und biegt dieses in seine Öffnungslage auf. Der Flachbandleiter 2 kann nun am Einführende 28 der Kontaktierungsvorrichtung 1 eingeschoben werden.

Die Stützelemente 6 dienen als seitliche Führung für den Flachbandleiter 2, die gewährleistet, dass die Leiterbahnen. 15 des Flachbandleiters 2 bezüglich der Kontaktelemente 4 richtig positioniert sind. Um einen guten Halt des Flachbandleiters 2 in der Kontaktierungsvorrichtung 1 zu erzielen, insbesondere um eine Verdrillung des Flachbandleiters 2 im Kontaktbereich zu verhindern, sind die Stützelemente 6 an ihrer der Leiterplatte 3 zugewandten Seite mit einer Führungskontur 31 versehen, die zusammen mit der anliegenden Leiterplatte 3 eine Führungsnut 32 für den Flachbandleiter 2 bildet. In den einander zugewandten Führungsnuten 32 ist der Flachbandleiter 2 randseitig von drei Seiten umfasst, wodurch eine gute Justierung des Flachbandleiters 2 und ein Verdrillungsschutz erreicht ist.

Der Flachbandleiter 2 wird mit einem Kontakende 32 voran in das Einführende 28 der Kontaktierungsvorrichtung 1 eingeschoben. Am Kontaktende 33 ist der Flachbandleiter 2 zumindest einseitig entisoliert, so dass seine Leiterbahnen 15 zumindest an der von der Leiterplatte 3 abgewandten Seite offenliegen. Die Kontaktierungsvorrichtung 1 ist derart auf den zu kontaktierenden Flachbandleiter 2 abgestimmt, das auf axialer Höhe einer jeden Leiterbahn 15 ein Kontaktelement 4 angeordnet ist.

Dies ermöglicht nun nach dem Einschieben des Flachbandleiters 2 die Kontaktierung desselben. Hierzu wird das Handhabungselement 5 gemäß FIG 4 in seine Schließstellung zurückverschwenkt und an den Stützelementen 6 verrastet. Dabei durchdringen die Haltedornen 22 den Flachbandleiter 2 und fixieren diesen somit mechanisch an der Leiterplatte 3. Bei der Rückverschwenkung des Handhabungselements 5 in seine Schließstellung wird der Exzentervorsprung 30 wiederum aus dem Anlagebereich mit den Kontaktelementen 4 herausverschwenkt. Die Kontaktelemente 4 gehen dabei aufgrund ihrer Eigenelastizität in die Ruhelage zurück. Das Kontaktende 33 des Flachbandleiters 2 ist somit zwischen dem Klemmende 14 des Kontaktelements 4 und der Leiterplatte 3 eingeklemmt. Dabei liegt jeweils das Klemmende 14 eines Kontaktierungselements auf dem endisolierten Bereich einer zugehörigen Leiterbahn 15 des Flachbandleiters 2 auf. Die Leiterbahn 15 des Flachbandleiters 2 ist somit über das Kontaktelement 4 mit einer zugehörigen Leiterbahn 12 der Leiterplatte 3 kurzgeschlossen.

Die Verbindung zwischen dem Flachbandleiter 2 und der Leiterplatte 3 kann zerstörungsfrei wieder gelöst werden, indem gemäß FIG 3 das Handhabungselement wiederum in seine Öffnungsstellung verschwenkt wird. Der Flachbandleiter 2 kann dann quasi kräftefrei entnommen werden.

### Bezugszeichenliste

- 1: Kontaktierungsvorrichtung
- 2: Flachbandleiter
- 3: Leiterplatte.
- 4: Kontaktelement
- 5: Handhabungselement
- 6: Stützelement
- 7: Befestigungsschenkel
- 8: Klemmschenkel
- 9: Bogensegment
- 10: Befestigungsende
- 11: Kontaktschwert
- 12: Leiterbahn
- 13: Bohrung
- 14: Klemmende
- 15: Leiterbahn
- 16: Achse
- 17: Hebelarm
- 18: Querbalken
- 19a,19b: Ansatzscheibe
- 20: Oberseite
- 21: Griff
- 22: Haltedorn
- 23: Rastnase
- 24: Rastaufnahme
- 25: Bohrung
- 26: Vorsprung
- 27: Aufnahme
- 28: Einführende
- 29: Klemmbereich,
- 30: Exzentervorsprung
- 31: Führungskontur
- 32: Führungsnut
- 33: Kontaktende
- 34: Anschlag
- 35: Rechteckkontur

## Patentansprüche

1. Kontaktierungsvorrichtung (1) zur Kontaktierung eines flexiblen Flachbandleiters (2) an einer Leiterplatte (3), mit mindestens einem Kontaktelement (4), welches mit einem Befestigungsende (10) an der Leiterplatte (3) befestigt ist, und welches mit einem Klemmende (14) in einer Ruhelage unter Vorspannung an der Leiterplatte (3) anliegt, sowie mit einem Handhabungselement (5), mittels welchem das Klemmende (14) des oder jedes Kontaktelements (4) aus der Ruhelage reversibel in eine Öffnungslage auslenkbar ist, in welcher das oder jedes Klemmende (14) von der Leiterplatte (3) einen zum drucklosen Einführen des Flachbandleiters (2) ausreichenden Abstand aufweist, **dadurch gekennzeichnet, daß** jeweils eine Leiterbahn (15) des Flachbandleiters (2) über ein Kontaktelement (4) mit einer zugehörigen Leiterbahn (12) der Leiterplatte (3) kurzschließbar ist.

2. Kontaktierungsvorrichtung (1) nach Anspruch 1, **dadurch gekennzeichnet, dass** das Befestigungsende (10) des oder jedes Kontaktelements (4) in die Leiterplatte (3) eingepresst ist.

3. Kontaktierungsvorrichtung (1) nach Anspruch 1 oder 2, **gekennzeichnet durch** mehrere Kontaktelemente (4), deren Klemmenden (14) mittels des Handhabungselements (5) simultan auslenkbar sind.

4. Kontaktierungsvorrichtung (1) nach einem der Ansprüche 1 bis 3, **dadurch gekennzeichnet, dass** das oder jedes Kontaktelement (4) bandartig oder stabartig ausgebildet ist und eine hakenartig gebogene Form aufweist.

5. Kontaktierungsvorrichtung (1) nach einem der Ansprüche 1 bis 4, **dadurch gekennzeichnet, dass** das Handhabungselement (5) eine parallel zur Leiterplatte (3) drehbeweglich geführte Achse (16) und mindestens einen etwa radial von der Achse (16) abstehenden Hebelarm (17) umfasst.

6. Kontaktierungsvorrichtung (1) nach Anspruch 5, **dadurch gekennzeichnet , dass** ein Bogensegment (9) des oder jedes Kontaktelements (4) dicht um den Umfang der Achse (16) herumgeführt ist.

7. Kontaktierungsvorrichtung (1) nach Anspruch 5 oder 6, **dadurch gekennzeichnet, dass** das Handhabungselemeht (5) um die Achse (16) reversibel von einer Schließstellung in eine Öffnungsstellung verschwenkbar ist, und dass die Achse (16) zumindest im Bereich jedes Kontaktelements (4) einen Exzentervorsprung (30) aufweist, der in der Öffnungsstellung das Kontaktelement (4) auslenkend beaufschlagt, und der in der Schließstellung aus dem Anlagebereich zwischen Kontaktelement (4) und Achse (16) herausgeschwenkt ist.

8. Kontaktierungsvorrichtung (1) nach einem der Ansprüche 5 bis 7, **dadurch gekennzeichnet, dass** mindestens ein Hebelarm (17) des Handhabungselements (5) einen Haltedorn (22) als Zugsicherung für den Flachbandleiter (2) aufweist, wobei der Haltedorn (22) in der Schließstellung dicht an der Leiterplatte (3) anliegt oder in diese eindringt.

9. Kontaktierungsvorrichtung (1) nach einem der Ansprüche 1 bis 8, **gekennzeichnet durch** Rastmittel (23,24), mittels welchen das Handhabungselement (5) in der Schließstellung fixierbar ist.

10. Kontaktierungsvorrichtung (1) nach einem der Ansprüche 1 bis 9, **gekennzeichnet durch** seitliche Stützelemente (6), zwischen denen die Achse (16) drehbar gelagert ist.

11. Kontaktierungsvorrichtung (1) nach Anspruch 10, **dadurch gekennzeichnet, dass** die Stützelemente (6) zur seitlichen Führung des Flachbandleiters (2) ausgebildet sind.

12. Kontaktierungsvorrichtung (1) nach Anspruch 11, **dadurch gekennzeichnet, dass** zwischen jedem Stützelement (6) und der Leiterplatte (3) eine Führungsnut (32) für den Flachbandleiter (2) gebildet ist.

13. Kontaktierungsvorrichtung (1) nach einem der Ansprüche 10 bis 12, **dadurch gekennzeichnet, dass** das Handhabungselement (5) in Schließstellung an den Stützelementen (6) verrastet ist.

14. Kontaktierungsvorrichtung (1) nach einem der Ansprüche 10 bis 13, **dadurch gekennzeichnet, dass** das Klemmende (14) bezüglich der Leiterplatte (3) konvex gebogen ist.

## Claims

1. A contacting device (1) for contacting a flexible flat strip conductor (2) to a printed circuit board (3), with at least one contacting element (4), which is attached with an attachment end (10) to the printed circuit board (3), and which with one terminal end (14) sits in a neutral position under bias voltage on the printed circuit board (3), and with a handling element (5), with which the terminal end (14) of the/each contact element (4) can be reversibly turned out into an opening position, in which the/each terminal end (14) comprises a sufficient distance from the printed circuit board (3) in order to guide in the flat strip conductor (2) without applying pressure, **characterized in that** in each case one track conductor (15) of the flat strip conductor (2) can be short-circuited via a contacting element (4) with a corresponding track conductor (12) on the printed circuit board (3).

2. A contacting device (1) according to claim 1, **characterized in that** the attachment end (10) of the/each contacting element (4) is pressed into the printed circuit board (3).

3. A contacting device (1) according to either of claims 1 or 2, **characterized by** several contacting elements (4), the terminal ends (14) of which can simultaneously be turned out using the handling element (5).

4. A contacting device (1) according to any one of claims 1 to 3, **characterized in that** the/each contacting element (4) is designed as a strip or rod, and comprises a hook-like, bent form.

5. A contacting device (1) according to any one of claims 1 to 4, **characterized in that** the handling element (5) comprises an axis (16), which can be rotated, in parallel to the printed circuit board (3), and at least one lever arm (17) which is positioned approximately radially from the axis (16).

6. A contacting device (1) according to claim 5, **characterized in that** a curved segment (9) of the/each contacting element (4) is lead tightly around the circumference of the axis (16).

7. A contacting device (1) according to either of claims 5 or 6, **characterized in that** the handling element (5) can reversibly be swivelled around the axis (16) from a closed position into an opening position, and that the axis (16), at least in the are of each contacting element (4), comprises an eccentric protrusion (30), which in the opening position impinges on the contacting element (4) when it is turned outwards, and which in the closed position is swivelled outwards from the installation area between the contacting element (4) and the axis (16).

8. A contacting device (1) according to any one of claims 5 to 7, **characterized in that** at least one lever arm (17) of the handling element (5) comprises a retaining pin (22) in order to secure the tension for the flat strip conductor (2), whereby the retaining pin (22) lies tightly on, or penetrates, the printed circuit board (3) when in the closed position.

9. A contacting device (1) according to any one of claims 1 to 8, **characterized by** latching elements (23, 24), with which the handling element (5) can be fixed in the closed position.

10. A contacting device (1) according to any one of claims 1 to 9, **characterized by** side support elements (6), between which the axis (16) is rotatably supported.

11. A contacting device (1) according to claim 10, **characterized in that** the support elements (6) are designed for guiding the sides of the flat strip conductor (2).

12. A contacting device (1) according to claim 11, **characterized in that** between each support element (6) and the printed circuit board (3), a guide groove (32) is formed for the flat strip conductor (2).

13. A contacting device (1) according to any one of claims 10 to 12, **characterized in that** the handling element (5) is latched in the closed position on the support elements (6).

14. A contacting device (1) according to any one of claims 10 to 13, **characterized in that** the terminal end (14) is bent convexly in relation to the printed circuit board (3).

## Revendications

1. Dispositif de mise en contact (1) pour la mise en contact d'un conducteur à ruban (2) flexible sur une carte imprimée (3), avec au moins un élément de contact (4) qui est fixé avec une extrémité de fixation (10) sur la carte imprimée (3), et qui appuie sous prétension sur la carte imprimée (3) avec une extrémité de serrage (14) dans une position de repos, ainsi qu'avec un élément de manipulation (5) au moyen duquel l'extrémité de serrage (14) de l'élément de contact (4) ou de chaque élément de contact (4) peut être déviée de façon réversible depuis la position de repos vers une position d'ouverture dans laquelle l'extrémité de serrage (14) ou chaque extrémité de serrage (14) de la carte imprimée (3) présente un intervalle suffisant pour l'introduction sans pression du conducteur à ruban (2), **caractérisé en ce que** respectivement une piste conductrice (15) du conducteur à ruban (2) peut être mise en court-circuit, via un élément de contact (4), avec une piste conductrice (12) associée de la carte imprimée (3).

2. Dispositif de mise en contact (1) selon la revendication 1, **caractérisé en ce que** l'extrémité de fixation (10) de l'élément de contact (4) ou de chaque élément de contact (4) est introduite par pression dans la carte imprimée (3).

3. Dispositif de mise en contact (1) selon la revendication 1 ou 2, **caractérisé par** plusieurs éléments de contact (4) dont les extrémités de serrage (14) peuvent être déviées simultanément au moyen de l'élément de manipulation (5).

4. Dispositif de mise en contact (1) selon une des revendications 1 à 3, **caractérisé en ce que** l'élément de contact (4) ou chaque élément de contact (4) est constitué à la façon d'un ruban ou d'une barre et présente une forme courbée à la façon d'un crochet.

5. Dispositif de mise en contact (1) selon une des revendications 1 à 4, **caractérisé en ce que** l'élément de manipulation (5) englobe un axe (16) guidé, de façon mobile en rotation, parallèlement à la carte imprimée (3), et au moins un bras de levier (17) faisant saillie à peu près de façon radiale par rapport à l'axe (16).

6. Dispositif de mise en contact (1) selon la revendication 5, **caractérisé en ce qu'**un segment arqué (9) de l'élément de contact (4) ou de chaque élément de contact (4) est guidé de façon serrée tout autour de la circonférence de l'axe (16).

7. Dispositif de mise en contact (1) selon la revendication 5 ou 6, **caractérisé en ce que** l'élément de manipulation (5) peut être amené à pivoter de façon réversible autour de l'axe (16) depuis une position de fermeture vers une position d'ouverture, et **en ce que** l'axe (16) présente, au moins dans la zone de chaque élément de contact (4), une saillie à excentrique (30) qui, dans la position d'ouverture, agit en déviation sur l'élément de contact (4) et qui, dans la position de fermeture, est mise en pivotement hors de la zone d'appui entre l'élément de contact (4) et l'axe (16).

8. Dispositif de mise en contact (1) selon une des revendications 5 à 7, **caractérisé en ce que** au moins un bras de levier (17) de l'élément de manipulation (5) présente une broche de retenue (22) en tant que protection contre la traction pour le conducteur à ruban (2), la broche de retenue (22) appuyant dans la position de fermeture de façon serrée sur la carte imprimée (3) ou pénétrant dans cette dernière.

9. Dispositif de mise en contact (1) selon une des revendications 1 à 8, **caractérisé par** des moyens de crantage (23, 24) au moyen desquels l'élément de manipulation (5) peut être fixé dans la position de fermeture.

10. Dispositif de mise en contact (1) selon une des revendications 1 à 9, **caractérisé par** des éléments d'appui (6) latéraux entre lesquels l'axe (16) est mis sur palier en rotation.

11. Dispositif de mise en contact (1) selon la revendication 10, **caractérisé en ce que** les éléments d'appui (6) sont constitués pour le guidage latéral du conducteur à ruban (2).

12. Dispositif de mise en contact (1) selon la revendication 11, **caractérisé en ce que**, entre chaque élément d'appui (6) et la carte imprimée (3), il est formé une rainure de guidage (32) pour le conducteur à ruban (2).

13. Dispositif de mise en contact (1) selon une des revendications 10 à 12, **caractérisé en ce que** l'élément de manipulation (5) est, dans la position de fermeture, engagé par crantage sur les éléments d'appui (6).

14. Dispositif de mise en contact (1) selon une des revendications 10 à 13, **caractérisé en ce que** l'extrémité de serrage (14) est courbée de façon convexe par rapport à la carte imprimée (3).
